# EUROPEAN PATENT SPECIFICATION

(11) **EP 0 456 256 B1**
(45) Date of publication and mention of the grant of the patent: **15.11.1995**
(21) Application number: 91107615.6
(22) Date of filing: 10.05.1991
(51) Int. Cl.: H01L 21/82, H01L 27/115, G11C 16/04

(54) **Method of manufacturing nonvolatile semiconductor memory device**
Verfahren zur Herstellung einer nichtflüchtigen Halbleiterspeicheranordnung
Méthode pour fabriquer un dispositif semi-conducteur de mémoire rémanente

(30) Priority: 11.05.1990 JP 119950/90
(43) Date of publication of application: 13.11.1991
(73) Proprietor: KABUSHIKI KAISHA TOSHIBA, Kawasaki-shi, Kanagawa-ken 210 (JP)
(72) Inventor: Araki, Hitoshi, c/o Int. Pty. Div., K.K. Toshiba, Tokyo 105 (JP)
(74) Representative: Lehn, Werner, Dipl.-Ing.

(56) References cited:
- PATENT ABSTRACTS OF JAPAN vol.14, no.259 (E-937)(4202) 5June 1990 & JP-A-2 079 477
- PATENT ABSTRACTS OF JAPAN vol. 14, no. 348 (E-957)(4291)27 JULY 1990 & JP-A-2 122 570
- PATENT ABSTRACTS OF JAPAN vol. 13, no. 445 (E-829)(3793) 6 October 1989 & JP-A-1 171 229

## Description

The present invention relates to a method of manufacturing a nonvolatile semiconductor memory device comprising gate electrode which is in an electrically floating state.

In a nonvolatile semiconductor memory device, the capability of retaining the written information, i.e., written charge, is an important factor in evaluating the reliability of the memory device. The charge retaining capability depends mainly on two factors. One of the factors is the quality of the oxide film covering the floating gate. If the quality of the oxide film is poor, the charge retaining capability of the memory device is deteriorated. Mobile ions such as ions of Na, K, and Li constitute another factor. Intrusion of the mobile ions from the outside can be prevented by using a BPSG film and a PSG film as the insulation film interposed between wiring layers and as a passivation film, respectively, because the mobile ions are gettered by the phosphorus contained in the BPSG film and the PSG film. However, it is difficult to prevent completely the intrusion of the mobile ions. In the actual nonvolatile semiconductor memory device, the reliability of the memory device is restricted by the mobile ions. The mobile ions intrude into the memory device through mainly the wiring contact. In an integrated circuit which is made finer and finer nowadays, the aspect ratio of the contact hole is on a sharp increase. The high aspect ratio brings about deterioration in the step coverage of the aluminum wiring and the passivation film.

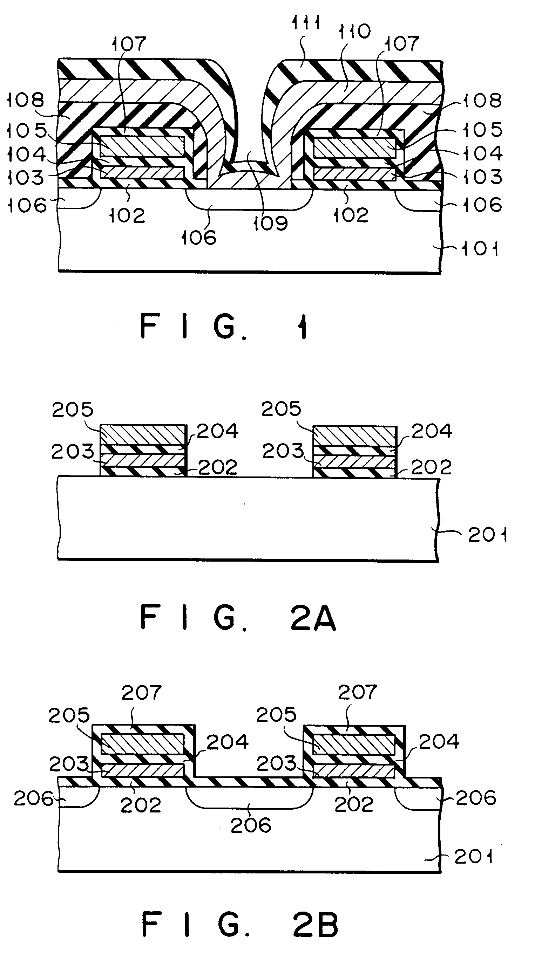

Fig. 1 shows a nonvolatile semiconductor memory device manufactured by the conventional method. As seen from the drawing, the memory device comprises a semiconductor substrate 101, a first insulation film 102, a floating gate 103, a second insulation film 104, a control gate 105, a source or drain region 106, a third insulation film 107, a fourth insulation film (BPSG film) 108, a contact hole 109, a wiring layer 110, and an insulation film (PSG film) 111 containing phosphorus. These films and layers are successively formed on the semiconductor substrate 101 using a patterning technique, etc.

In the conventional nonvolatile semiconductor memory device shown in Fig. 1, a high aspect ratio of the contact hole 109 brings about deterioration in the step coverage of the wiring layer 110 and the passivation film 111 at the portions facing the contact hole 109, with the result that the wiring layer 110 and the passivation film 111 are made very thin at the portions facing the contact hole 109. The mobile ions intrude through the thin portions of the wiring layer 110 and the passivation film 111 and migrate through the oxide film 107 so as to reach the floating gate 103 and, thus, to deteriorate the charge retaining capability of the memory device.

JP-A-1-171 229 discloses a nonvolatile semiconductor memory device similar to that discussed above in connection with figure 1. This memory device includes a first insulation film, a first gate electrode, a second insulation film, a second gate electrode, a third insulation film and a passivation film which is a BPSG-film formed by CVD-method. A wiring layer is formed on the passivation film and extending through respective holes to source or drain regions on the substrate of the semiconductor memory device. On the wiring layer and the first passivation film a second passivation film composed of a siliconenitrid film is formed by a plasma CVD-method.

An object of the present invention is to provide a method of manufacturing a nonvolatile semiconductor memory device which permits to improve the reliability, particularly, the charge retaining capability, of the nonvolatile semiconductor memory device.

In order to satisfy this object a method according to the precharacterizing part of claim 1 is provided with the characterizing features thereof.

The particular method of the present invention permits the upper portion of the contact hole to be closed with the fifth insulation film having a planarized (flattened) surface. Also, the phosphorus-containing insulation film formed on the fifth insulation film is uniform in thickness, making it possible to diminish markedly the mobile ions intruding into the nonvolatile semiconductor memory device from the outside. It follows that the present invention permits markedly improving the charge retaining capability of the memory cell.

This invention can be more fully understood from the following detailed description when taken in conjunction with the accompanying drawings, in which:
Fig. 1 is a cross sectional view showing a nonvolatile semiconductor memory device manufactured by the conventional method;
Figs. 2A to 2F are cross sectional views collectively showing how to manufacture a nonvolatile semiconductor memory device by a method according to one embodiment of the present invention; and
Fig. 3 is a graph showing the results of a comparative test between nonvolatile semiconductor memory devices manufactured by the conventional method and by the method of the present invention.

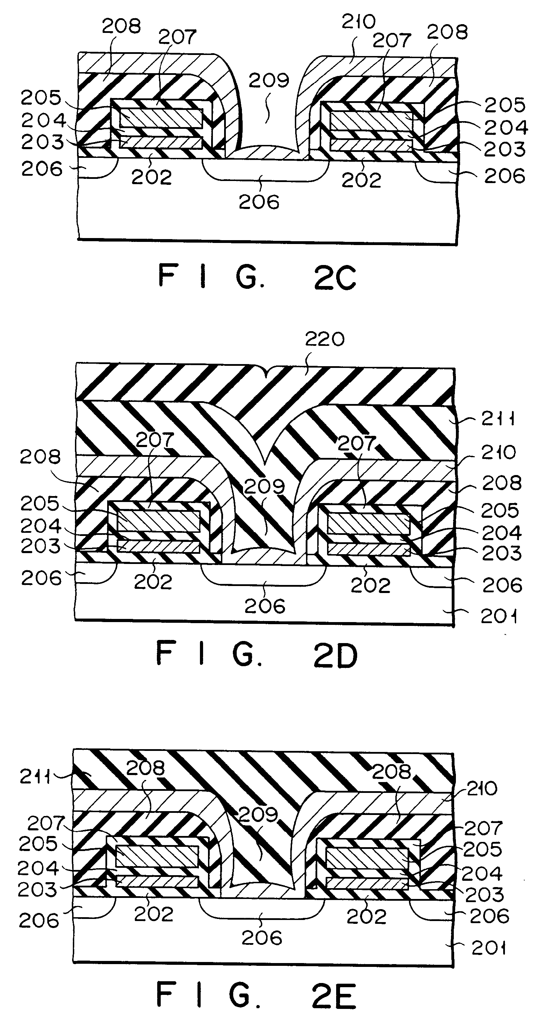

Figs. 2A to 2F collectively show a method of manufacturing a nonvolatile semiconductor memory device according to one embodiment of the present invention. As shown in Fig. 2A, a first insulation film 202 consisting of silicon dioxide is formed in a thickness of 20 nm (200 Å) on a semiconductor substrate 201 consisting of a p-type monocrystalline silicon. A laminate structure consisting of a first gate electrode 203 in direct contact with the first insulating film 202, a second insulation film 204 formed on the first gate electrode 203, and a second gate electrode 205 formed on the second insulation film 204 is formed on the first insulation film 202. The first gate electrode 203 acts as a floating gate and is prepared by depositing a polycrystalline silicon in a thickness of 200 nm (2000 Å). The second insulation film 204 consists of a silicon dioxide film 30 nm (300 Å) thick. Further, the second gate electrode 205 acts as a control electrode and is of a laminate structure 500 nm (5000 Å) thick, which consists of a polycrystalline silicon film and a silicide film. The laminate structure consisting of the films 202 to 205 is patterned so as to obtain a structure as shown in Fig. 2A.

In the next step, diffusion layers 206 providing a source region and a drain region are formed within the semiconductor substrate 201, as shown in Fig. 2B. An ion implantation of an n-type impurity, e.g., arsenic or phosphorus, is employed for forming the diffusion layers 206, with the gate laminate structure shown in Fig. 2A used as a mask. After formation of the diffusion layers 206, an insulation film 207 covering the substrate surface including the upper and side surfaces of the gate electrode 205 and the side surface of the gate electrode 203 is formed by thermal oxidation, followed by depositing a phosphorus-containing insulation film (BPSG film) 208, as shown in Fig. 2C. Then, a contact hole 209 is selectively formed in contact with the source or drain region 206, followed by forming an aluminum wiring layer 210. After formation of the aluminum wiring layer 210, a silicon oxide insulation film 211 is deposited on the aluminum wiring layer 210 by CVD (chemical vapor deposition) method at a temperature lower than the melting point of the aluminum wiring layer, e.g., at about 400°C, as shown in Fig. 2D. It is possible to employ any of a plasma CVD method using SᵢH₄, plasma CVD method using TEOS, and atmospheric-pressure CVD method using TECO and O₃ as the low-temperature CVD method noted above.

Where the surface of the insulation film 211 is not sufficiently flat as shown in Fig. 2D, the insulation film 211 is planarized by the etchback method as shown in Fig. 2E, followed by depositing a phosphorus-containing film (PSG film) 212 in a thickness of 500 nm (5000 Å), as shown in Fig. 2F. In the etchback method noted above, the insulation film 211 is coated with a resist 220 so as to fill the concavity formed on the surface of the insulation film 211, as shown in Fig. 2D. Then, the etchback is applied to the silicon oxide film 211 and the resist film 220 under the condition that the selectivity ratio of the silicon oxide film to the resist is small. If the resist 220 is partially left unremoved after the etching back treatment, the residual resist is removed so as to planarize (flatten) the surface of the silicon oxide film.

To be more specific, the resist film 220 is formed on the insulation film 211 as shown in Fig. 2D, followed by applying an etchback treatment to the resist film 220 and the insulation film 211 until the surface of the aluminum wiring layer 210 is exposed to the outside. If the concave portion of the insulation film 211 and the resist film positioned within the concave portion (or a region between adjacent wiring layers 210) are left within the contact hole portion after the etching back treatment, the residual resist film may be removed, followed by depositing again a silicon dioxide by the low temperature CVD method so as to obtain an insulation film 211 having a flat surface as shown in Fig. 2E. It is not absolutely necessary to apply the etching back treatment until the surface of the aluminum wiring layer is exposed to the outside. In other words, degree of the etchback treatment can be determined optionally as desired. Alternatively, it is desirable to form the insulation film 211 in a thickness greater than that shown in the drawing in the step shown in Fig. 2D, followed by forming a resist film on the thick insulation film. In this case, the resist film is etched back, and the etchback is applied to reach the intermediate portion of the insulation film 211 so as to obtain the insulation film 211 having a flat surface as shown in Fig. 2E. Incidentally, if the flatness of the surface of the insulation film 211 is insufficient even after the etching back treatment, it is possible to deposit again silicon dioxide by the low-temperature CVD method, followed by applying again an etching back treatment.

In the method of manufacturing a nonvolatile semi-conductor memory device described above with reference to Figs. 2A to 2F, the phosphorus-containing insulation film (PSG film) 212 is formed in a uniform thickness on the main body of the nonvolatile semiconductor memory device, making it possible to markedly improve the effect of preventing mobile ions from intruding from outside into the semiconductor memory device. In order to further improve the particular effect of the present invention, it is desirable to form the phosphorus-containing insulation film 211 by introducing, for example, a reaction gas containing phosphorus in the step of forming the insulation film 211 by the CVD method.

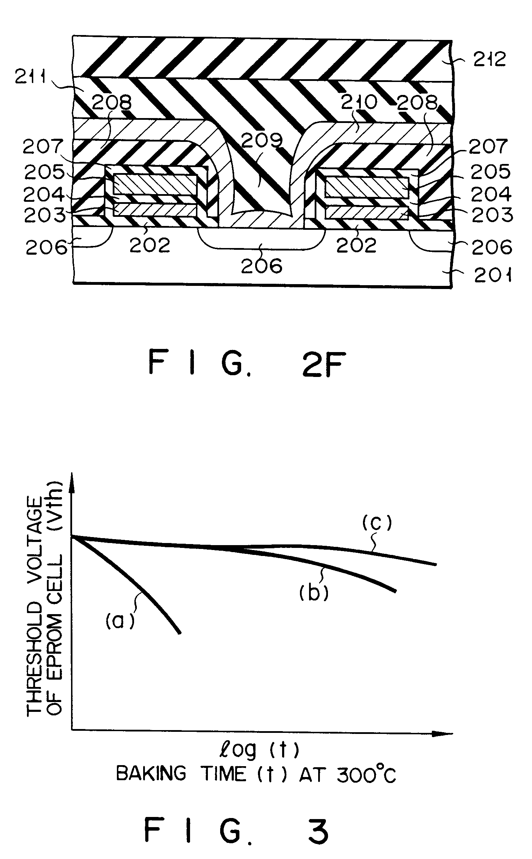

Fig. 3 is a graph showing the results of a high temperature baking test at 300°C, which was applied to a nonvolatile semiconductor memory device manufactured by the conventional method, said memory device constituting an EPROM (Erasable PROM), and to a nonvolatile semiconductor memory device manufactured by the method of the present invention, said memory device constituting an EPROM. The baking time [log (t)] is plotted on the abscissa in the graph of Fig. 3, with the threshold voltage of the nonvolatile semiconductor memory device being plotted on the ordinate. Curve (a) in Fig. 3 denotes the charge retaining capability of the nonvolatile memory device manufactured by the conventional method. On the other hand, curves (b) and (c) denote the charge retaining capability of the nonvolatile memory device manufactured by the method of the present invention, curve (b) covering the case where phosphorus is not contained in the insulation film 211 and curve (c) covering the case where phosphorus is contained in the insulation film 211. As clearly seen from Fig. 3, the nonvolatile semiconductor memory device manufactured by the method of the present invention is markedly advantageous in the charge retaining capability over the nonvolatile semiconductor memory device manufactured by the conventional method.

The present invention is not restricted to the embodiment described above. Of course, various modifications are available within the technical scope of the present invention. For example, a p-type monocrystalline silicon substrate was used in the embodiment described above. However, it is also possible to use an n-type monocrystalline silicon substrate in the present invention. In this case, an ion implantation of a p-type impurity, e.g., boron, is employed for forming the source and drain regions. Also, the second gate electrode 205 was formed of a laminate structure consisting of a polycrystalline silicon layer and a silicide layer in the embodiment described above. However, it is also possible to use a polycrystalline silicon layer alone or a silicide layer alone for forming the second gate electrode 205. Further, in the embodiment described above, an etchback method was employed for planarizing the surface of the insulation film 211. However, various methods including the use of inorganic or organic coating film can be employed for planarizing the surface of the insulation film 211. For example, in the method of using a coating film, an oxide film is formed on the aluminum wiring layer 210, followed by forming an inorganic or organic coating film so called spin-On-Glass (SOG) on the oxide film. Then, an etchback treatment is applied to the resultant laminate structure so as to planarize the coating film. Further, an oxide film is formed on the planarized coating film so as to provide the insulation film 211 of a laminate structure having a flat surface. The planarization (flattening) technique using a coating film also includes a method of annealing the coating formed in advance so as to provide a flat surface as shown in Fig. 2E. It should also be noted that the insulation film 211 was formed of silicon dioxide in the embodiment described above. However, it is also possible to use silicon nitride for forming the insulation film 211.

As described above in detail, the method of the present invention makes it possible to manufacture a nonvolatile semiconductor memory device exhibiting a markedly improved reliability, particularly, charge retaining capability.

Reference signs in the claims are intended for better understanding and shall not limit the scope.

## Claims

1. A method of manufacturing a nonvolatile semiconductor memory device comprising:
the step of preparing a main body of a nonvolatile semiconductor memory device including source and drain regions (206) of a second conductivity type formed on the surface region of a semiconductor substrate (201) of a first conductivity type, a first insulation film (202) formed on a channel region positioned between the source and drain regions, a first gate electrode (203) formed on the first insulation film in an electrically floating state, a second insulation film (204) formed on the first gate electrode, a second gate electrode (205) acting as a control electrode, which is formed on the second insulation film, a third insulation film (207) and a fourth insulation film (208) each formed on the substrate including the second gate electrode, contact holes (209) made through the third and fourth insulation films to the source or drain regions, and a first wiring layer (210) formed on the third and fourth insulation films and within the contact holes;
**characterized** by
the step of forming a fifth insulation film (211) on the fourth insulation film and on the first wiring layer, at a low temperature which does not exceed the melting point of the wiring layer (210) positioned below the fifth insulation layer (211);
the step of planarization of the surface of the fifth insulation film (211); and
the step of forming a sixth insulation film (212) containing phosphorus on the fifth insulation film (211).

2. The method of manufacturing a nonvolatile semiconductor memory device according to claim 1, characterized in that the fifth insulation film contains phosphorus.

3. The method of manufacturing a nonvolatile semiconductor memory device according to claim 1, characterized in that the surface of the fifth insulation film is planarized by a step of forming a resist layer (220) on the fifth insulation layer, and a step of etching back the resist layer and the fifth insulation film.

4. The method of manufacturing a nonvolatile semiconductor memory device according to claim 3, characterized in that the surface of the fifth insulation film is planarized by newly forming an insulation film on the exposed surface after the etchback treatment applied to the laminate structure consisting of the resist layer and the fifth insulation film.

5. The method of manufacturing a nonvolatile semiconductor memory device according to claim 1, characterized in that an inorganic coating film is used for forming the fifth insulation film.

6. The method of manufacturing a nonvolatile semiconductor memory device according to claim 1, characterized in that an organic coating film is used for forming the fifth insulation film.

7. The method of manufacturing a nonvolatile semiconductor memory device according to any one of claims 1, 5 and 6, characterized in that the fifth insulation film is planarized by means of heat treatment.

## Patentansprüche

1. Verfahren zur Herstellung einer nichtflüchtigen Halbleiterspeichervorrichtung mit dem Schritt des
Vorbereitens eines Hauptkörpers einer nichtflüchtigen Halbleiterspeichervorrichtung mit Source- und Drainbereichen (206) von einem zweiten Leitungstyp, die in dem Oberflächenbereich eines Halbleitersubstrats (201) von einem ersten Leitungstyp gebildet sind, einem ersten Isolationsfilm (202), der auf einem zwischen den Source- und Drainbereichen gelegenen Kanalbereich gebildet ist, einer ersten Gateelektrode (203), die auf dem ersten Isolationsfilm in einem elektrisch schwimmenden Zustand gebildet ist, einem zweiten Isolationsfilm (204), der auf der ersten Gateelektrode gebildet ist, einer als Steuerelektrode wirkenden, zweiten Gateelektrode (205), die auf dem zweiten Isolationsfilm gebildet ist, einem dritten Isolationsfilm (207) und einem vierten Isolationsfilm (208), von denen jeder auf dem Substrat einschließlich der zweiten Gateelektrode gebildet ist, Kontaktlöchern (209), die durch den dritten und vierten Isolationsfilm zu den Source- oder Drainbereichen gemacht sind, und einer ersten Verdrahtungsschicht (210), die auf den dritten und vierten Isolationsfilmen und in den Kontaktlöchern gebildet ist,
**gekennzeichnet** durch folgende Schritte:
Bilden eines fünften Isolationsfilms (211) auf dem vierten Isolationsfilm und auf der ersten Verdrahtungsschicht bei einer niedrigen Temperatur, welche den Schmelzpunkt der unter der fünften Isolationsschicht gelegenen Verdrahtungsschicht (210) nicht übersteigt,
Einebnen der Oberfläche des fünften Isolationsfilms (211), und
Bilden eines Phosphor enthaltenden, sechsten Isolationsfilms (212) auf dem fünften Isolationsfilm (211).

2. Verfahren zum Herstellen einer nichtflüchtigen Halbleiterspeichervorrichtung nach Anspruch 1, dadurch gekennzeichnet, daß der fünfte Isolationsfilm Phosphor enthält.

3. Verfahren zum Herstellen einer nichtflüchtigen Halbleiterspeichervorrichtung nach Anspruch 1, dadurch gekennzeichnet, daß die Oberfläche des fünften Isolationsfilms durch Bilden einer Resistschicht (220) auf der fünften Isolationsschicht und durch Rückätzen der Resistschicht und des fünften Isolationsfilms eingeebnet ist.

4. Verfahren zum Herstellen einer nichtflüchtigen Halbleiterspeichervorrichtung nach Anspruch 3, dadurch gekennzeichnet, daß die Oberfläche des fünften Isolationsfilms durch erneutes Bilden eines Isolationsfilms auf der nach der Rückätzbehandlung der aus der Resistschicht und dem fünften Isolationsfilm bestehenden, laminierten Struktur freigelegten Oberfläche eingeebnet wird.

5. Verfahren zum Herstellen einer nichtflüchtigen Halbleiterspeichervorrichtung nach Anspruch 1, dadurch gekennzeichnet, daß ein anorganischer Beschichtungsfilm zum Bilden des fünften Isolationsfilms benutzt wird.

6. Verfahren zum Herstellen einer nichtflüchtigen Halbleiterspeichervorrichtung nach Anspruch 1, dadurch gekennzeichnet, daß ein organischer Beschichtungsfilm zum Bilden des fünften Isolationsfilms benutzt wird.

7. Verfahren zum Herstellen einer nichtflüchtigen Halbleiterspeichervorrichtung nach einem der Ansprüche 1, 5 oder 6, dadurch gekennzeichnet, daß der fünfte Isolationsfilm mittels einer Wärmebehandlung eingeebnet wird.

## Revendications

1. Procédé de fabrication d'un dispositif de mémoire à semiconducteur non volatile comprenant :
l'étape de préparation d'un corps principal d'un dispositif de mémoire à semiconducteur non volatile incluant des régions de source et de drain (206) d'un second type de conductivité formées sur la région de surface d'un substrat semiconducteur (201) d'un premier type de conductivité, d'un premier film d'isolation (202) formé sur une région de canal positionnée entre les régions de source et de drain, d'une première électrode de grille (203) formée sur le premier film d'isolation dans un état électriquement flottant, d'un second film d'isolation (204) formé sur la première électrode de grille, d'une seconde électrode de grille (205) jouant le rôle d'électrode de commande, qui est formée sur le second film d'isolation, d'un troisième film d'isolation (207) et d'un quatrième film d'isolation (208) dont chacun est formé sur le substrat incluant la seconde électrode de grille, de trous de contact (209) réalisés au travers des premier et quatrième films d'isolation jusqu'aux régions de source ou de drain et d'une première couche de câblage (210) formée sur les troisième et quatrième films d'isolation et dans les trous de contact,
caractérisé par :
l'étape de formation d'un cinquième film d'isolation (211) sur le quatrième film d'isolation et sur la première couche de câblage, à une basse température qui n'excède pas le point de fusion de la couche de câblage (210) positionnée au-dessous de la cinquième couche d'isolation (211) ;
l'étape de planarisation de la surface du cinquième film d'isolation (211) ; et
l'étape de formation d'un sixième film d'isolation (212) contenant du phosphore sur le cinquième film d'isolation (211).

2. Procédé de fabrication d'un dispositif de mémoire à semiconducteur non volatile selon la revendication 1, caractérisé en ce que le cinquième film d'isolation contient du phosphore.

3. Procédé de fabrication d'un dispositif de mémoire à semiconducteur non volatile selon la revendication 1 caractérisé en ce que la surface du cinquième film d'isolation est planarisée par une étape de formation d'une couche de réserve (220) sur le cinquième film d'isolation et par une étape de nivellement par gravure de la couche de réserve et du cinquième film d'isolation.

4. Procédé de fabrication d'un dispositif de mémoire à semiconducteur non volatile selon la revendication 3, caractérisé en ce que la surface du cinquième film d'isolation est planarisée en formant à nouveau un film d'isolation sur la surface mise à nu après que le traitement de nivellement par gravure est appliqué à la structure stratifiée constituée par la couche de réserve et par le cinquième film d'isolation.

5. Procédé de fabrication d'un dispositif de mémoire à semiconducteur non volatile selon la revendication 1 caractérisé en ce qu'un film de revêtement inorganique est utilisé pour former le cinquième film d'isolation.

6. Procédé de fabrication d'un dispositif de mémoire à semiconducteur non volatile selon la revendication 1, caractérisé en ce qu'un film de revêtement organique est utilisé pour former le cinquième film d'isolation.

7. Procédé de fabrication d'un dispositif de mémoire à semiconducteur non volatile selon l'une quelconque des revendications 1, 5 et 6 , caractérisé en ce que le cinquième film d'isolation est planarisé au moyen d'un traitement thermique.
